# EUROPEAN PATENT SPECIFICATION

(11) **EP 4 368 958 B1**
(45) Date of publication and mention of the grant of the patent: **09.07.2025**
(21) Application number: 22206104.6
(22) Date of filing: 08.11.2022
(51) Int. Cl.: G01M 7/08, H01M 10/42

(54) **BATTERY TESTING APPARATUS**
BATTERIEPRÜFVORRICHTUNG
APPAREIL DE TEST DE BATTERIE

(43) Date of publication of application: 15.05.2024
(73) Proprietor: Rimac Technology d.o.o., 10431 Sveta Nedelja (HR)
(72) Inventor: Obad, Emil, 10360 Sesvete (HR)
(74) Representative: Peterreins Schley

(56) References cited:
- CN-A- 109 444 746
- CN-A- 113 607 564
- DE-A1- 102019 105 064
- JP-B2- 4 634 244
- US-A1- 2008 148 863
- US-B1- 9 488 562
- HSU T T C ET AL: "A UNIVERSAL PANEL TESTER", JOURNAL OF TESTING AND EVALUATION, AMERICAN SOCIETY FOR TESTING AND MATERIALS. PHILADELPHIA, US, vol. 23, no. 1, 1 January 1995 (1995-01-01), pages 41 - 49, XP000501118, ISSN: 0090-3973

## Description

### TECHNICAL FIELD

The present disclosure relates to the field of battery testing, more specifically to a device for battery testing.

### BACKGROUND

Increasing electrification, especially in the automotive industry, is visibly shifting the focus in the corresponding research and development. Particular attention has recently been paid to the development of new batteries and battery technologies, especially with regard to power density, materials, and range. The behavior of battery cells or batteries in the event of traffic accidents or other physical impacts on the battery is also an area that still requires extensive research in the development of modern electrified and battery-powered vehicles. For the occupants of a passenger car and for the rescue forces, the risks in the event of an accident must be reduced. To this end, there is a need for testing facilities to test the battery for possible design-related hazards during development or to analyze the behavior of the battery in different situations and improve the battery if necessary. In particular, the effects of mechanical impacts on the battery in different constellations, which can occur in an accident, for example, need to be investigated. Existing test procedures include the complete or partial destruction of the battery, also under electrical voltage. For this purpose, elaborate test apparatus may be necessary, for example to protect the test equipment from explosions, fire ignition or other emissions that may result from testing the battery.

Complex and time-consuming test procedures make the development of the battery more expensive. Often, many different test runs of the battery at different electrical settings are necessary, for example at different states of charge. But also the temperature and in particular the way of mechanical impact on the battery or battery cells have an influence on the test results.

US9488562 B1 discloses a battery impact testing system according to the preamble of claim 1.

Therefore, there is a fundamental need for test apparatuses and test setups that allow fast, flexible testing of batteries and that further develop and improve existing test rigs for batteries, also with a view to reducing costs in the development of batteries and/or quality and safety checks.

### SUMMARY

According to a first aspect, an actuator device for battery testing is provided. The actuator device comprises a housing comprising a rack and at least one protective panel which is mounted on the rack through attachment means, and at least one impact device which is configured to impact a battery and which is attached to the housing, wherein at least one protective panel of the at least one protective panel is an impact device protective panel comprising an opening through which an impact member of the impact device is passed towards the battery, characterized in that, the impact device can be attached to the housing on a side of a first side and a second side of the impact device protective panel which faces away from the battery.

According to a second aspect, there is provided a support frame. The support frame is configured to fix a battery, wherein an actuator device in accordance with the techniques of the first aspect or its embodiments is attached to the support frame through connecting means such that the battery can be impacted from one or more directions.

An effect of the technique of the present specification is to provide an actuator device for battery testing that may result in various advantages.

One particular advantage may be that the actuator device may allow flexible and cost-efficient battery testing. The flexibility in mounting the impact device on various sides of the housing allows the battery to be tested from different directions and with different angles of impact on the battery. Furthermore, the impact device can be mounted from one side to another during a test procedure without having to release the battery from a fixation, for example. Another advantage is that more than one impact devices can be mounted to the housing at the same time and tests can be carried out from several directions at the same time or one after the other without having to interchange the impact device between different test runs. This also provides an advantage in terms of increased safety during battery testing. By eliminating the need for conversions of the actuator device during a battery test, a test expert, for example, may not need to approach or make conversions to the actuator device until the test is complete. In addition to the safety aspect, the time required for a complete battery test can be reduced because no conversions are necessary between the individual test runs if, for example, all the necessary impact devices can already be attached to the housing at the start of the test.

Due to the flexible design and the possibility to test batteries of different dimensions, for example by using height-adjustable fixing devices or the support frame, which also allows testing of larger battery units, the techniques disclosed herein can make battery testing more cost-efficient. For example, the actuator device and support frame can be used to test and analyze individual battery cells, battery modules, or battery packs for mechanical impact, such as nail and crush penetration. The compact design of the actuator device also allows flexible use in climatic chambers or blast boxes.

The protective panels may protect the impact device from the consequences of the battery test. Furthermore, a flexible number of protective panels can be attached to the rack so that, if necessary, the battery can be shielded inside or parts of the test assembly may be protected from the battery in case of explosion, fire, or emission of other parts or gases during a mechanical impact test. Protecting test components and/or the impact device may lead to their reusability and thus may reduce battery testing costs.

Further embodiments of the techniques disclosed herein allow automation of battery testing when, for example, a larger number of batteries need to be tested, for example by using an automatic feeding device.

### BRIEF DESCRIPTION OF THE DRAWINGS

Other characteristics will be apparent from the accompanying drawings, which form a part of this disclosure. The drawings are intended to further explain the present disclosure and to enable a person skilled in the art to practice it. However, the drawings are intended as non-limiting examples. Common reference numerals on different figures indicate like or similar features.
- **Figure 1a**: schematically illustrates an example of an actuator device with at least one impact device attached to a first side or a second side of the housing in an exploded view, according to an embodiment of the present disclosure;
- **Figure 1b**: schematically illustrates an example of an actuator device with at least one impact device attached to the first side of the housing, according to an embodiment of the present disclosure;
- **Figure 2a**: schematically illustrates an example of an actuator device with at least one impact device attached to the second outer side of the housing, according to an embodiment of the present disclosure;
- **Figure 2b**: schematically illustrates an example of an actuator device with at least two impact devices attached to various sides of the housing, according to an embodiment of the present disclosure;
- **Figure 3**: schematically illustrates an example of an actuator device with an automatic feeding device, according to an embodiment of the present disclosure;
- **Figure 4a**: schematically illustrates an example of a support frame with an actuator device attached to the support frame at a first side, according to an embodiment of the present disclosure;
- **Figure 4b**: schematically illustrates an example of a support frame with an actuator device attached to the support frame at a second side, according to an embodiment of the present disclosure;
- **Figure 4c**: schematically illustrates an example of a support frame with an actuator device attached to the support frame at a third side, according to an embodiment of the present disclosure; and
- **Figure 5**: schematically illustrates an example of a support frame comprising one or more protective transparent panels and one or more cameras, according to an embodiment of the present disclosure.

The drawings referred to in this description are not to be understood as being drawn to scale except if specifically noted, and such drawings are only exemplary in nature.

An embodiment thereof has been shown by way of example in the drawings and will be described here below.

The term "comprises", comprising, or any other variations thereof, are intended to cover a non-exclusive inclusion, such that a setup, structure or method that comprises a list of components or steps does not include only those components or steps but may include other components or steps not expressly listed or inherent to such setup or structure or method. In other words, one or more elements in a system or apparatus proceeded by "comprises... a" does not, without more constraints, preclude the existence of other elements or additional elements in the system or apparatus.

For better understanding of this invention, reference would now be made to the embodiment illustrated in the accompanying Figures and description here below, further, in the following Figures, the same reference numerals are used to identify the same components in various views.

References throughout the preceding specification to "one embodiment", "an embodiment", "one example" or "an example", "one aspect" or "an aspect" means that a particular feature, structure, or characteristic described in connection with the embodiment or example is included in at least one embodiment of the present disclosure. Thus, appearances of the phrases "in one embodiment", "in an embodiment", "one example" or "an example", "one aspect" or "an aspect" in various places throughout this specification are not necessarily all referring to the same embodiment or example.

Furthermore, the particular features, structures, or characteristics can be combined in any suitable combinations and/or sub-combinations in one or more embodiments or examples.

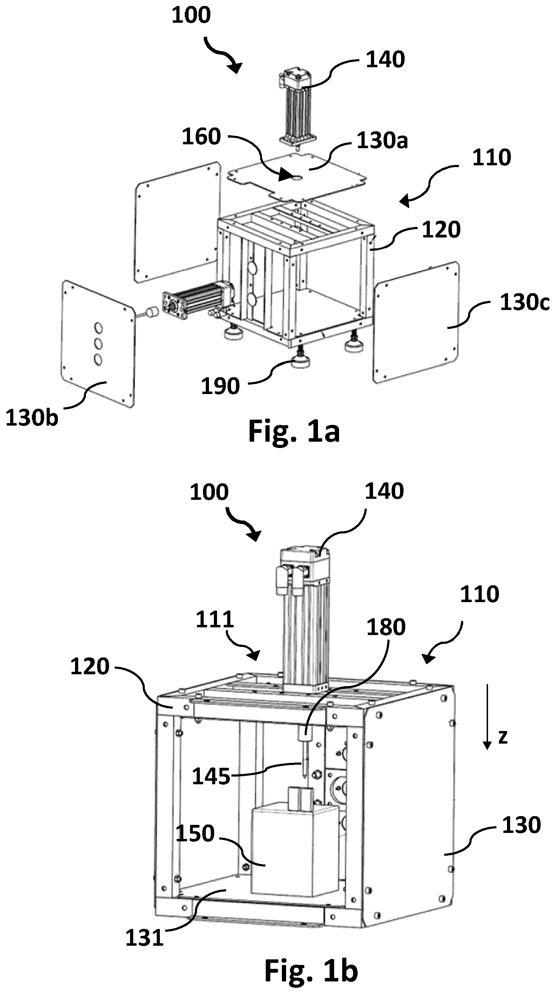

**FIG. 1a** schematically illustrates an example of an actuator device 100 with at least one impact device 140 attached to a first side or a second side of the housing 110 in an exploded view.

According to the first aspect, the actuator device comprises a housing 110 comprising a rack 120 and at least one protective panel 130 which is mounted on the rack 120 through attachment means, and at least one impact device 140 which is configured to impact a battery 150 and which is attached to the housing 110, wherein at least one protective panel of the at least one protective panel 130 is an impact device protective panel 130a comprising an opening 160 through which an impact member 145 of the impact device 140 is passed towards the battery 150, characterized in that, the impact device 140 can be attached to the housing 110 on a side of a first side and a second side of the impact device protective panel 130a which faces away from the battery 150. In an example, the rack 120 may form a cuboid with sides of different lengths or a cube with sides of the same length. In another example, the rack 120 may form a prismatic shape with sides of different lengths. For example, as shown in **FIG. 1a**, the rack 120 may have feet 190 such that there is a spacing between the rack 120 and a floor. In an example, the feet 190 may be adjustable in height. In an example, the feet 190 may comprise threaded shafts, and may be adjustable in height, for example, by rotation. In an example, the feet 190 may include an adherent surface facing towards floor or a platform, to prevent the actuator device 100 from sliding. In an example, the rack 120 may be constructed from a plurality of trusses. In an example, the plurality of trusses may be bolted together to form the rack 120. In an example, the plurality of trusses may be welded together to form the rack 120. In an example, the at least one protective panel 130 may be a sheet having a thickness in a range from 0.5 mm to 1 mm, 1 mm to 2 mm, 2 mm to 3 mm, 3 mm to 4 mm, 4 mm to 5 mm, 5 mm to 7 mm, or more. For example, one or more side lengths of the rack 120 may be in a range from 200 mm to 300 mm, 300 mm to 400 mm, 400 mm to 500 mm, 600 mm to 700 mm, 700 mm to 800 mm, 800 mm to 1000 mm, or more. For example, different sides of the rack 120 may have different lengths according to the aforementioned ranges.

In an embodiment, the attachment means may comprise screw and female thread joints comprising a plurality of internal threads in the rack 120, holes in the at least one protective panel 130, and screws configured to fix the at least one protective panel 130 on the rack 120, or wherein the attachment means comprises bolt and nut joints comprising threaded bolts on the rack 120, holes in the at least one protective panel 130, and nuts configured to fix the at least one protective panel 130 on the rack 120, or wherein the attachment means comprises bolt and nut joints comprising holes in the rack 120, threaded bolts on the at least one protective panel 130, and nuts configured to fix the at least one protective panels 130 on the rack 120, or wherein the attachment means comprises screw and nut joints comprising holes in the rack 120, holes in the at least one protective panel 130, and screws and nuts configured to fix the at least one protective panels 130 on the rack 120.

**FIG. 1b** schematically illustrates an example of an actuator device with at least one impact device attached to a first side 111 of the housing 110.

In an example and as shown in **FIG. 1b**, the attachment means such as threaded holes and/or bolts may also be provided on a side of the rack 120 to which the at least one protective panel 130 is not attached to provide the ability to attach the at least one protective panel 130 to a side other than the first outer side 111 of the housing 110. This may be advantageous to mount the impact device 140 to a different side of the housing 110 during battery testing. For example, the impact device protective panel 130a or 130b as shown in **FIG. 1a** may include attachment means, such as threaded holes, through holes, and/or bolts (not shown), to allow the impact device 140 to be attached to impact device protective panel 130a or 130b. In this regard, the impact device protective panel 130a or 130b is configured to allow the impact device 110 to be attached to both surfaces/sides of the at least one protective panel 130. In an example and as shown in **FIG. 1b**, the impact device 140 may be attached to the first outer side 111 of the housing 110 when, for example, the battery 150 is arranged inside the rack 120. The impact device protective panel may be arranged between the impact device 140 and the first outer side 111 of the housing 110 (not shown in **FIG. 1b**) For example, in a case where the battery 150 is arranged inside the rack 120, the impact may be performed by the impact device 140 from the outside to the inside, towards the battery 150. In an example, the impact device 140 may be attached to a first inner side of the housing 110 such that the impact device 140 is arranged inside the rack 120 (not shown). For example, in a case where the battery 150 is arranged outside of the rack 120, an impact may be performed by the impact device 140 from the inside to the outside, that is, in a direction away from the rack 120. In an example, the impact device protective panel 130a or 130b may be configured to allow the impact device 140 to be mechanically connected to the rack 120, such as by a threaded connection. In an example, the impact device protective panel 130a or 130b may include through holes for screws or bolts to mechanically couple the impact device 140 to the rack 120. In an example, the through holes may be arranged around the opening 160. For example, the at least one protective panel 130 and/or the attachment means may be configured to be mounted to the rack 120 with an inner side facing outward, or to be mounted to the rack 120 with an inner side facing inward.

In general, the at least one protective panel 130 may be configured to protect the at least one impact device 140 in the case of a fire, an explosion, and/or emissions emitted by the battery 150 during testing. This may be advantageous in view of the reusability and protection of further testing equipment and the impact device 140 which may be affected by side effects of the battery test.

In an embodiment, the housing 110 may comprise at least two protective panels 130, wherein the at least two protective panels 130 are configured to be mounted to various sides of the housing 110. **FIG. 1a** illustrates a case where multiple protective panels are attached to the rack 120. For example, one of the at least two protective panels may be an impact device protective panel 130a to which the impact device 140 is attached. In this case, the impact device protective panel may protect the impact device 140 from side effects of the battery test such as explosion, and the remaining second protective panel 130c of the at least two protective panels 130 may protect, for example, other test components and/or persons from side effects of the battery test. In an example, the protective panel 130c of the at least two protective panels 130 that is not an impact device protective panel may not have an opening 160 but a closed surface. As mentioned above, the at least two protective panels 130 and/or the attachment means may be configured to allow the at least two protective panels 130 to be attached on different sides of the housing 110. This may be advantageous, for example, in order to be able to perform a plurality of different test runs. For example, in a first case, a first protective panel of the at least two protective panels 130 may be attached to a first side of the housing 110 and a second protective panel of the at least two protective panels 130 may be attached to a second side of the housing 110. In a second case, the first protective panel may be attached to the former position of the second protective panel and the second protective panel may be attached to the former position of the first protective panel. In an example, the at least two protective panels 130 may be interchanged with each other.

In an embodiment, the housing 110 may comprise at least two protective panels 130, wherein at least two of the at least two protective panels 130 are impact device protective panels 130a, 130b and wherein the at least one impact device 140 can be interchangeably attached to the first protective panel 130a or the second protective panel 130b. **FIG. 1a** shows exemplary two possibilities for attaching the impact device 140 to the first protective panel 130a or the second protective panel 130b. For example, the opening 160 of the first protective panel 130a may be closed with a closure element, e.g., a plug, when the impact device 140 is attached to the second protective panel 130b. For example, the impact device 140 may be attached to the first protective panel 130a in a first test run and attached to the second protective panel 130b in a second test run, for example to perform an impact on the battery 150 from different directions. As explained above, the protective panels 130a, 130b can be attached to various sides of the housing 110.

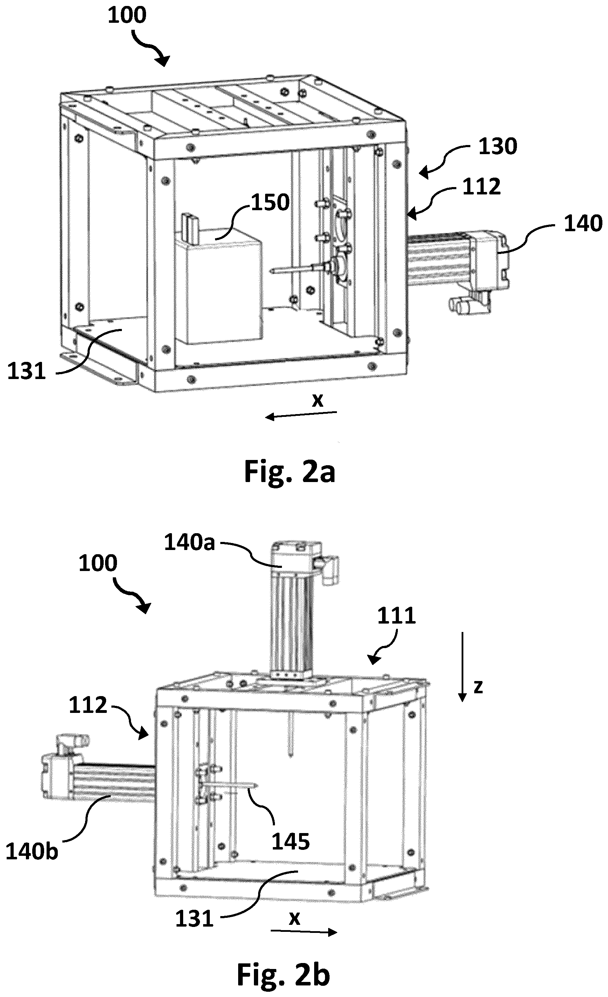

**FIG. 2b** schematically illustrates an example of an actuator device 100 with at least two impact devices 140a, 140b attached to various sides of the housing 110. In an example, multiple impact devices 140, but at least two impact devices 140a, 14b may be attached to various sides of the housing 110. For example, two or more impact devices 140 may be advantageous when, for example, two or more test runs are performed in succession, or simultaneously, without requiring modification of the actuator device 100. **FIG. 2b** is an exemplary illustration of an actuator device 100 without a protective panel 130 for ease of illustration. In an example, the impact device 140a and/or the impact device 140b may be mounted directly to the rack 120 with at least two impact device protective panels (not shown) disposed between each of the impact devices 140a, 140b and the corresponding side of the housing 110. For example, through holes in the protective panels 130 may allow the impact devices 140a, 140b to be mounted directly to the rack 120.

In an embodiment, the position of the bolts, holes or internal threads of the rack 120 matches the position of the holes or bolts of the least two protective panels 130 such that each of the at least two protective panels can be mounted on the rack 120 in place of another protective panel of the at least two protective panels. In an example, the first protective panel 130a can be mounted in place of the second protective panel 130b and vice versa. This embodiment may have the advantage that any protective panel may be attached to any side of the rack 120. This may have the advantage that an impact on the battery 150 may be performed, for example, from different directions. This means that the attachment means are designed to allow each of the at least two protective panels to be mounted on the rack 120 in place of another protective panel of the at least two protective panels 130. This allows flexibility to attach different protective panels 130a, 130b to different sides of the housing 110.

In an embodiment, the rack 120 and/or the at least two protective panels 130 may further comprise positioning means such as holes in the rack 120 and bolts at the at least two protective panels or vice versa, wherein the positioning means are configured to position the at least two protective panels 130 on the rack 120 such that an outer circumferential surface of the housing 110 is at least partially closed. For example, when mounting the at least two protective panels 130, the position means may serve to position the at least two protective panels 130 such that, for example, a gap between the first protective panel 130a and the second protective panel 130b of the at least two protective panels 130 may be reduced. In an example, the actuator device 100 may include at least three protective panels, at least four protective panels, at least five protective panels, or at least six protective panels. In an example, each or a part of the protective panels 130 may be positioned using the positioning means to, for example, substantially close a portion of the circumferential surface of the housing 110. This may be advantageous, for example, to keep gases or emissions leaking from the battery 150 inside the housing 110 and away from test equipment, people, and/or the impact device 140 during the battery test.

In an embodiment, the at least two protective panels 130 may have the same external dimensions. In an example, the housing 110 may have a plurality of equally sized sides such that the at least two protective panels 130 may be attached to any of the plurality of equally sized sides of the housing 110. For example, it may be advantageous that the at least two protective panels may have the same dimensions, and thus can be interchanged with each other. For example, the at least two protective panels 130 may be impact device protective panels, such that having the same external dimension allows the impact device to be attached to various sides of the housing 110 as shown in **FIG. 1a**.

In an embodiment one panel of the at least two protective panels 130 may form a fixation panel 131. The actuator device 100 further comprises a fixation device optionally attached to the fixation panel 131 and configured to at least fix the battery 150 inside the housing 110. Returning to **FIG. 1b**, the fixation panel 131 may be a bottom panel of the actuator device 100. In an example, the fixation device may be arranged on the bottom panel fixating the battery 150 for testing. In an example, the fixation device may be mounted on the rack 120 optionally without contacting any protective panel 130. In an example, the fixation panel 131 may be attached to any other side of the rack 120 of the actuator device 100. In an example, the fixation device may be adjustable at least in a first direction z perpendicular to the fixation panel 131, in a second direction x parallel to the fixation panel 131, and/or in a third direction y parallel to the fixation panel 131 and perpendicular to the second direction x. For example, the fixation device may be designed in the form of a chuck. For example, the fixation device may be manually or automatically adjustable in the first direction, the second direction and/or the third direction by means of rails and clamps or by means of threaded rods and internal threads.

In an embodiment, one panel of the at least two protective panels 130 may form a fixation panel 131, and wherein the impact device 140 may be attached to a first outer side 111 of the housing 110 opposite the fixation panel 131, and wherein the impact on the battery 150 may be performed in a first direction z perpendicular to the fixation panel 131. **FIG. 1b** shows an exemplary arrangement of the impact device 140 opposite the fixation panel 131. The protective panel which is not the fixation panel may form the impact device protective panel (not shown) to which the impact device 140 may be attached. As already mentioned above, the impact device 140 may be directly mechanically coupled to the rack 120, wherein the impact device protective panel may be inbetween the impact device 140 and the rack 120 and may allow the impact device 140 to be mechanically coupled to the rack 120. This may be advantageous to increase mechanical stability during battery testing.

**FIG. 2a** shows another arrangement of the impact device 140 which may be an alternative to the arrangement of **FIG. 1b** or may be in addition to the arrangement of **FIG. 1b****.**

In an embodiment, and as exemplarily shown in **FIG. 2a**, one panel of the plurality of protective panels may form a fixation panel 131 and wherein the impact device 140 may be attached to a second outer side 112 of the housing 110 that is perpendicular to the fixation panel 131 and wherein the impact on the battery 150 is performed in a second direction x parallel to the fixation panel 131. The second direction x may be perpendicular to the first direction z. The fixation panel 131 of **FIG. 2a** may be the same fixation panel 131 of **FIG. 1b**. In an example, the fixation panel 131 may serve as an area where to put the battery for testing, wherein the fixation device configured to at least fix the battery may be optionally attached to the fixation panel 131.

In an embodiment, the impact device 140 may be attached to a third outer side of the housing 110 that is perpendicular to the second outer side 112 and the fixation panel 131 and wherein the impact on the battery 150 is performed in a third direction parallel to the fixation panel 131 and perpendicular to the second direction x parallel to the fixation panel 131. This may be advantageous to allow the battery 150 to be tested from various directions, e.g., at least from the first direction z, the second direction x, and/or the third direction y. In an example, the impact device 140 may be sequentially attached to the first side, the second side, and/or the third side of the housing 110.

In an embodiment, the actuator device 100 may comprise at least two impact devices 140, wherein each of the at least two impact devices 140 may be attached to a side of the first outer side, the second outer side, or the third outer side of the housing 110 to which the other impact device is not attached. This may result in the advantage that, for example, the battery 150 can be tested simultaneously from at least two directions, or can be tested sequentially from at least two directions, without requiring modification of the actuation device 100.

In an embodiment, the actuator device 100 may comprise at least three impact devices 140, wherein each of the at least three impact devices 140 may be attached to the side of the first outer side, the second outer side, or the third outer side of the housing 110 to which none of the other two impact devices of the at least three impact devices is attached. This may result in the advantage that, for example, the battery 150 can be tested simultaneously from at least three directions, or can be tested sequentially from at least three directions, without requiring modification of the actuation device 100.

In an embodiment, the at least one impact device 140 may comprise a linear actuator, such as an electrical linear motor or a pneumatic cylinder, a hydraulic cylinder, a captive bolt gun, a shot apparatus, or a retensioning device. In an example, the impact device 140 may be configured to perform a linear movement to impact the battery 150. In an example, the actuation device 100 may comprise a control unit that provides, for example, an electrical drive signal or a trigger signal to the impact device 140. In an example, the actuation device 100 may further comprise a computer system. In an example, the computer system may comprise a communication interface that receives, for example, data to start the battery test. In an example, the actuation device 100 may be connected to a remotely located computer system via electrical lines, wherein the remotely located computer system may be configured to provide a drive signal or a trigger signal to the impact device 140. In an example, a pneumatic air supply system may be provided to provide necessary compressed air to a pneumatic cylinder forming the impact device 140. In the case of hydraulics, an oil pump may be provided that provides necessary pressurized hydraulic oil, for example via hoses, to the impact device 140 to perform linear motion. In the case of a shot apparatus, a remote ignition may be provided that may be triggered, for example, via a radio link. This may be advantageous to protect persons from side effects of the battery test.

In an embodiment, the impact member 145 may comprise an end section comprising a nail, a needle, a bolt, or a projectile, or spherical or prismatic ball, configured to impact the battery. Returning to **FIG. 2b**, a needle exemplarily forms the end section of the impact member 145. In an example, impacting the battery 150 may comprise penetrating the battery. In an example, a needle forming the end section of the impact member 145 may be advantageous to perform penetration of the battery 150. In an example, the impact member 145 may be configured to apply pressure to a side surface of the battery 150 without penetrating an outer surface of the battery 150. In an example, deformation of the battery 150 may occur. In an example, the impact member 145 may have a flat surface that contacts an outer surface of the battery 150. In an example, the impact member 145 may include a bolt that optionally penetrates the battery 150 through the outer surface of the battery 150 during a test. In an example, the impact member 145 may comprise a shaft and/or an adaptor 180 configured to mechanically couple the end section to the impact device 140.

In an embodiment, the actuator device 100 may further comprise the battery 150 to be tested, wherein the battery 150 may be at least one of a battery cell, a battery module, or a battery pack, and wherein the battery 150 may be arranged inside or outside the housing 110, wherein the at least one impact device 140 may be inside the housing 110 in case the battery 150 is arranged outside the housing 110 and wherein the at least one impact device 140 may be outside the housing 110 when the battery 150 is arranged inside the housing. As mentioned above, and exemplarily shown in FIG. 1a, the impact device 140 is attached to the housing 110 on a side of the first side and the second side of the protective panel 130 serving as impact device protective panel which faces away from the battery 150. The impact device 140 may be attached to the housing 110 inside or outside the housing 110 depending on the arrangement of the battery 150. The impact device 140 may be attached to the housing 110 such that the impact device 140 may perform impacting the battery 150 either outwardly, that is, away from the actuation device 100, or inwardly, depending on the arrangement of the battery 150.

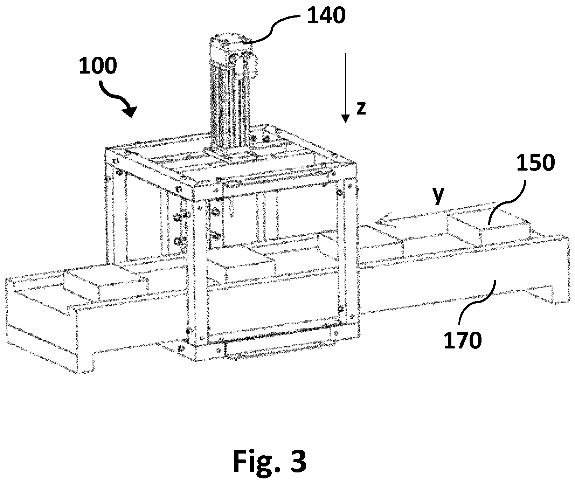

**FIG. 3** schematically illustrates an example of an actuator device 100 with an automatic feeding device 170.

In an embodiment, the actuation device 100 may further comprise an automatic feeding device 170, configured to sequentially insert a plurality of batteries 150 into the interior of the housing 110 of the actuator device 100, and to allow the plurality of batteries 150 to be tested by the impact device 140. For example, a plurality of batteries may be tested sequentially in the form of series tests. In an example, a test of one battery of a plurality of batteries may be performed randomly. For example, the automatic feeding device 170 may comprise position sensors so that, for example, one battery at a time may be automatically positioned in the actuation device 100 to be tested. In an example, the position sensors may comprise light sensors, inductive sensors, capacitive sensors, or magnetic sensors, but are not limited to said sensors. In an example, the automatic feeding device 170 comprises a conveyor belt inserting the plurality of batteries in a first feeding direction y, wherein the first feeding direction y forms a predetermined angle with a direction z in which the impact may be performed. In an example, the predetermined angle is about 90°, or in a range from 30° to 90°, or from 90 ° to 150°. In an example, the impact may be performed perpendicular to the feeding direction y. In an example, the automatic feeding device may be connected to the computer system. The computer system may be configured to provide driving signals and/or control signals to the automatic feeding device. For example, the automatic feeding device 170 may have a timing that allows a feeding to be paused for a predetermined period of time to allow a battery of the plurality of batteries to be tested by the actuation device 100. In an example, the feeding of the plurality of batteries may be performed using a robotic arm or an automatic feeding table. The automatic feeding may be advantageous to test a plurality of batteries in a cost-effective manner and/or with reduced amount of time.

In an embodiment, the material of the rack 120 and/or the protective panel 130 may comprise stainless steel. In an example, the material of the rack 120 and/or the protective panel 130 may comprise steel, galvanized steel, painted steel, aluminum, or a combination thereof. In an example, the rack 110 may be a weld assembly. In general, the housing may be configured to protect the impact device 140, further test equipment, and/or persons involved in testing from side effects of the battery testing, such as explosion, fire, emissions from the battery, and/or hazards related to electrical voltage or current.

In an example, the actuator device 100 may comprise a temperature sensor located inside the housing 110 and configured to measure environmental temperature inside the housing 110 during testing. In an example, the actuator device 100 may comprise a temperature sensor located inside the battery 150 or attached to the battery 150. For example, measuring the temperature may be advantageous, for example to determine room temperature for starting the battery test and/or to record the temperature profile of the battery and/or the environment during the testing procedure. For example, the temperature sensor may be connected to an evaluation unit and/or the computer system to record the signal from the temperature sensor and/or provide it visually to a user, for example. In an example, the temperature sensor inside the housing 110 and/or the temperature sensor inside the battery 150 or at the battery 150 may be one of a thermocouple, a thermistor, a resistance temperature sensor, or an infrared sensor, or a combination thereof. In an example, the temperature sensor may be attached to a positive tab of the battery 150, to a negative tab of the battery 150, and/or the surface of the battery 150. In an example, a plurality of temperature sensors may be attached to the battery. In an example, the temperature sensor may be located at 1/8 of the battery length, at one-half of the battery length, and/or at 7/8 of the battery length.

In an example, the actuation device 100 may further comprise a pressure sensor or a load cell located inside the housing (110). In an example the pressure sensor may be connected to the computer system. For example, the pressure sensor and/or load cell may be used to record the pressure profile during the test procedure, for example by means of the computer system. In an example, the pressure curve can be visually displayed to the user.

In an example, the impact device may be configured to apply a force in a range from 4 kN to 16,5 kN to impact the battery 150. In an example, the force may serve to penetrate the battery 150, or apply pressure to the outer surface of the battery 150. In an example, the force applied may be dependent on the impact member 145 and/or the end section. In an example, the impact member 145 may have a velocity in a range from 0,1 mm/s to 127 mm/s when impacting the battery 150. In an example, the velocity may remain constant over the distance that the impact member 145 covers to the outer surface of the battery 150. In an example, the velocity may increase or decrease over the distance that the impact member 145 covers to the battery 150. For example, in a case when the battery is penetrated, the velocity of the impact member 145 may decrease starting from the point the impact member 145 enters the battery. In an example, the velocity of the impact member 145 may remain constant after entering the battery 150, or may maintain the velocity that the impact member 145 has at the point when entering the battery 150. In an example, the impact device 140b may be configured to penetrate the battery 150 and wherein the penetration depth of the impact member is in a range from 1 mm to 150 mm when penetrating the battery 150. In an example, for penetrating the battery 150 the impact member 145 may comprise a needle or a nail as an end section.

In an embodiment, the housing 110 may comprise at least three protective panels interchangeably mounted on the rack, at least four protective panels interchangeably mounted on the rack 120, at least five protective panels interchangeably mounted on the rack 120, or at least six protective panels interchangeably mounted on the rack 120. **FIG. 1a** illustrates the exemplary case where at least six protective panels may be mounted to the rack 120, wherein two protective panels 130a, 130b of the at least six protective panels 130 may be impact device protective panels. In an example, the housing 110 may be (nearly) completely enclosed through the protective panels. In an example, only a portion of the sides of the racks 120 may be closed with protective panels 130. In an example, the at least three protective panels, at least four protective panels, at least five protective panels, or at least six protective panels may be interchangeable with each other and/or each may be mounted on different sides of the rack 120. For example, different numbers of the at least three protective panels, at least four protective panels, at least five protective panels, or at least six protective panels may be impact device protective panels, meaning that a plurality of impact devices 140 may be attached to each protective panel that is an impact device protective panel. As mentioned above, each opening 160 of an impact device protective panel may be closed in the case no impact device 140 is attached to the respective impact device protective panel.

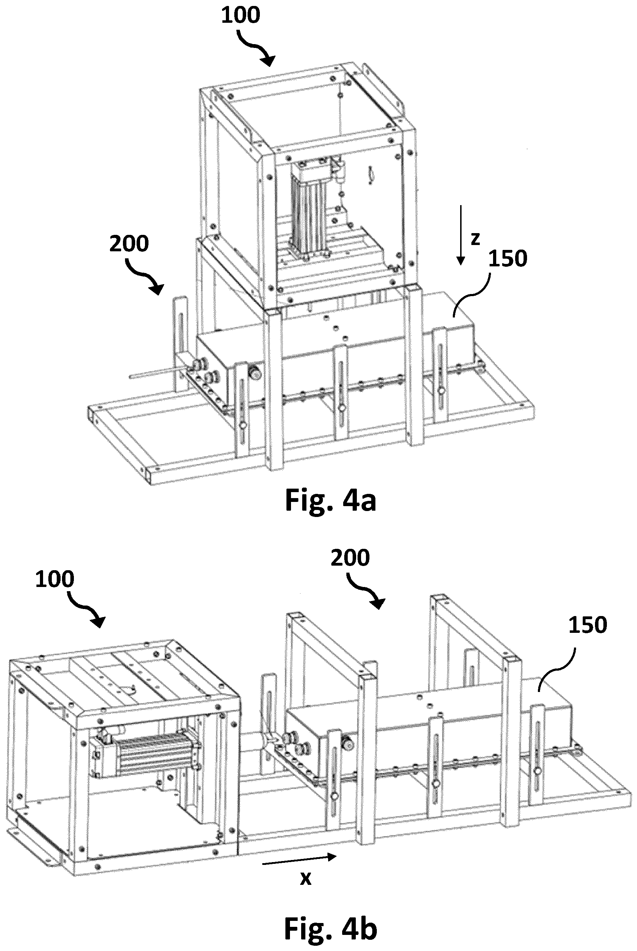

The following description refers to **FIGS. 4a** to **5****.**

According to a second aspect, the support frame 200 may be configured to fix a battery 150, wherein an actuator device 100 in accordance with the techniques and embodiments of the first aspect may be attached to the support frame 200 through connecting means such that the battery 150 can be impacted from one or more directions. The support frame may serve to test a battery pack. In an example, a battery pack may comprise a plurality of single battery cells, prismatic pouch, or cylindrical. The support frame 200 may be advantageous to test a battery 150, a battery cell, a battery pack, or a battery stack whose outer dimensions exceed those suitable to be tested inside the housing of the actuator device 100.

**FIG. 4a** schematically illustrates an example of the support frame 200 with the actuator device 100 attached to the support frame 200 at a first side.

In an embodiment, the actuator device 100 may be attached to the support frame 200 at the first side such that the impact device 140 impacts the battery from a first direction z.

**FIG. 4b** schematically illustrates an example of the support frame 200 with the actuator device 100 attached to the support frame 200 at a second side.

In an embodiment, the actuator device 100 may be attached to the support frame 200 at a second side such that the impact device 140 impacts the battery 150 from a second direction x perpendicular to the first direction z. In an example, the impact device 140 may be mounted inside the housing 110, or on a side of the impact device protective panel facing away from the battery 150.

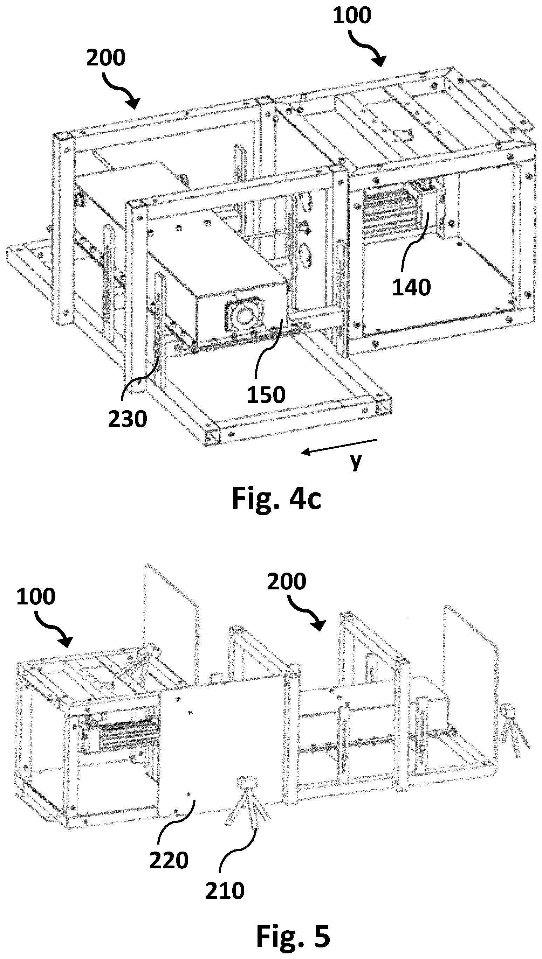

**FIG. 4c** schematically illustrates an example of a support frame 200 with an actuator device 100 attached to the support frame 200 at a third side.

In an embodiment, the actuator device 100 may be attached to the support frame 200 at a third side such that the impact device 140 impacts the battery 150 from a third direction y perpendicular to the first direction z and the second direction x. Generally, the actuator device 100 may be attached to the first side, the second side, or the third side of the support frame 200 such that the impact device 140 is arranged inside the actuator device 100. In an example, the impact is performed outwardly, that is, away from the actuator device 100 towards the battery 150 arranged inside the support frame 200. Arranging the impact device 140 inside the actuator device 100 may serve to protect the impact device 140 during testing of the battery 150. In an example, the connecting means may comprise screws and nuts joints, screw and female thread joints, or a locking mechanism.

**FIG. 5** schematically illustrates an example of the support frame 200 comprising one or more protective transparent panels 220 and one or more cameras 210.

In an embodiment, the support frame 200 may comprise one or more cameras 210 configured to record the battery testing. In an example, it may be advantageous to record the battery testing for subsequent analysis. In an example, the one or more cameras 210 may comprise thermal imaging cameras. The thermal imaging cameras may be configured to locate locations on the battery where temperature rises during battery testing. In an example, the one or more cameras 210 may be connected to the computer system. In an example, the computer system may include a memory on which the recording is stored. In an example, the one or more cameras 210 may include its own memory or a memory card.

In an embodiment, the support frame 200 may comprise a support assembly 230 adjustable in the first direction z, the second direction x, the third direction y, and/or a predetermined rotating angle, and configured to allow the impact device 140 of the actuator device 100 to impact the battery 150 from one or more directions. In an example, the battery 150 may be supported by the support assembly 200. For example, the support assembly 200 may comprise cross members on which the battery may be positioned. In an example, the cross members may be adjustable in height via a screw clamp running vertically in an elongated hole. In an example, the support assembly 200 may also be horizontally adjustable by means of rails on the support frame 200. In an example, the support assembly may also have rails that are inclined at a predetermined rotating angle to the first direction z, the second direction x, and/or the third direction y along which the impact is performed.

In an example, the support assembly 230 may be configured to fix the battery 150 during testing. Fixing of the battery 150 may be achieved by means of a clamp or chuck. In an example, a screw thread may be used to apply a clamping force to the battery 150 to fix the battery in the support assembly 230. The fixing may be used to build up a counterforce when the impact device 140 impacts the battery 150.

In an embodiment, the support frame 200 may further comprise one or more protective transparent panels 220 configured to protect the one or more cameras 210 during testing of the battery. **FIG. 5** shows exemplary one or more protective transparent panels 220 arranged between the one or more cameras 210 and the actuation device 210 and/or the battery 150. In an example, the material of the protective transparent panels 220 may comprise glass, polycarbonate, or polyvinyl chloride, or any other suitable transparent material. In an example, the one or more protective transparent panels 220 may be configured to protect further test equipment.

In an embodiment, the computer system may be configured to store test instructions and may be configured to provide driving signals to the support assembly 230 for adjusting in the first direction z, the second direction x, the third direction y, and/or the predetermined rotating angle, to receive signals from one or more detection sensors attached to the housing 110 configured to detect the at least one protective panel mounted on the rack, to provide driving signals to the impact device based on the test instructions, and to record the outcome of the battery test based on the output from at least one of the temperature sensor, the pressure sensor, or the one or more cameras 210. In an example, the computer system may comprise at least one of a central processing unit (CPU) and a memory. The memory may comprise at least one of a randomaccess memory (RAM) or a read-only memory (ROM). The test instructions may be stored in the memory in the form of software code or a software-based instruction list. In an example, the support assembly 230 may be adjustable in the first direction z, the second direction x, the third direction y, and/or a predetermined rotating angle by means of an electrical drive configured to receive the driving signals provided by the computer system. The one or more detection sensors may comprise light sensors, inductive sensors, capacitive sensors, magnetic sensors, or a mechanical pushbutton switch, but are not limited to said sensors.

In order to summarize, the techniques provided herein may lead to the following advantages.

One particular advantage may be that the actuator device may allow flexible and cost-efficient battery testing. The flexibility in mounting the impact device on various sides of the housing allows the battery to be tested from different directions and with different angles of impact on the battery. Furthermore, the impact device can be mounted from one side to another during a test procedure without having to release the battery from a fixation, for example. Another advantage is that several impact devices can be mounted to the housing at the same time and tests can be carried out from several directions at the same time or one after the other without having to change the impact device between different test runs. This also provides an advantage in terms of increased safety during battery testing. By eliminating the need for conversions during a battery test, a test expert, for example, does not need to approach or make conversions to the actuator device until the test is complete. In addition to the safety aspect, the time required for a complete battery test can be reduced because no conversions are necessary between the individual test runs if, for example, all the necessary impact devices can already be attached to the housing at the start of the test.

Due to the flexible design and the possibility to test batteries of different dimensions, for example by using height-adjustable fixing devices or the support frame, which also allows testing of very large battery units, the techniques disclosed herein can make battery testing more cost-efficient. For example, the actuator device and support frame can be used to test and analyze individual battery cells, battery modules, or battery packs for mechanical impact, such as nail and crush penetration. The compact design of the actuator device also allows flexible use in climatic chambers or blast boxes.

The protective panels may protect the impact device from the consequences of the battery test. Furthermore, a flexible number of protective panels can be attached to the rack so that, if necessary, the battery can be shielded inside or parts of the test assembly may be protected from the battery in case of explosion, fire or emission of other parts or gases during a mechanical impact test. Protecting test components and/or the impact device may lead to their reusability and thus may reduce battery testing costs.

Further embodiments of the techniques disclosed herein allow automation of battery testing when, for example, a larger number of batteries need to be tested, for example by using an automatic feeding device.

## Claims

1. An actuator device (100) for battery testing, comprising;
a housing (110) comprising
a rack (120) and
at least one protective panel (130) which is mounted on the rack (120) through attachment means; and
at least one impact device (140) which is configured to impact a battery (150) and which is attached to the housing (110), wherein at least one protective panel (130) of the at least one protective panel (130) is an impact device protective panel comprising an opening (160) through which an impact member (145) of the impact device (140) is passed towards the battery (150),
**characterized in that**,
the impact device (140) can be attached to the housing (110) on a side of a first side and a second side of the impact device protective panel (130) which faces away from the battery (150).

2. The actuator device (100) according to claim 1, wherein the housing (110) comprises at least two protective panels (130), wherein the at least two protective panels (130) are configured to be mounted to various sides of the housing (110).

3. The actuator device (100) according to claim 1 or 2, wherein the housing (110) comprises at least two protective panels (130), wherein at least two of the at least two protective panels (130) are impact device protective panels (130a, 130b) and wherein the at least one impact device (140) can be interchangeably attached to the first protective panel (130a) or the second protective panel (130b).

4. The actuator device (100) according to claim 3, wherein one panel of the at least two protective panels (130) forms a fixation panel (131), the actuator device (100) further comprising a fixation device optionally attached to the fixation panel (131) and configured to at least fix the battery (150) inside the housing (110).

5. The actuator device according to any one of claims 3 or 4, wherein one panel of the at least two protective panels (130) forms a fixation panel (131), and wherein the impact device (140) is attached to a first outer side (111) of the housing (110) opposite the fixation panel (131), and wherein the impact on the battery (150) is performed in a first direction z perpendicular to the fixation panel (131).

6. The actuator device 10 according to any one of claims 3 to 5, wherein one panel of the plurality of protective panels forms a fixation panel (131) and wherein the impact device (140) is attached to a second outer side (112) of the housing (110) that is perpendicular to the fixation panel (131) and wherein the impact on the battery (150) is performed in a second direction x parallel to the fixation panel (131).

7. The actuator device (100) according to any one of claims 3 to 6, wherein the impact device (140) is attached to a third outer side of the housing (110) that is perpendicular to the second outer side (112) and the fixation panel (131) and wherein the impact on the battery (150) is performed in a third direction parallel to the fixation panel (131) and perpendicular to the second direction x parallel to the fixation panel (131).

8. The actuator device (100) according to claim 7, wherein the actuator device (100) comprises at least two impact devices (140), wherein each of the at least two impact devices (140) is attached to a side of the first outer side, the second outer side, or the third outer side of the housing (110) to which the other impact device is not attached.

9. The actuator device (100) according to any one of the preceding claims, wherein the at least one impact device (140) comprises a linear actuator, such as an electrical linear motor or a pneumatic cylinder, a hydraulic cylinder, a captive bolt gun, a shot apparatus, or a retensioning device.

10. The actuator device (100) according to any one of the preceding claims, wherein the impact member (145) comprises an end section comprising a nail, a needle, a bolt, or a projectile, or spherical or prismatic ball, configured to impact the battery.

11. The actuator device (100) according to claim 10, wherein the impact member (145) comprises a shaft and/or an adaptor (180) configured to mechanically couple the end section to the impact device (140).

12. The actuator device (100) according to any one of the preceding claims, further comprising an automatic feeding device (170), configured to sequentially insert a plurality of batteries (150) into the interior of the housing (110) of the actuator device (100), and to allow the plurality of batteries (150) to be tested by the impact device (140).

13. The actuator device (100) according to any one of the preceding claims, wherein the housing (110) comprises at least three protective panels interchangeably mounted on the rack, at least four protective panels interchangeably mounted on the rack (120), at least five protective panels interchangeably mounted on the rack (120), or at least six protective panels interchangeably mounted on the rack (120).

14. A support frame (200), configured to fix a battery (150), wherein an actuator device (100) according to any one of the preceding claims is attached to the support frame (200) through connecting means such that the battery (150) can be impacted from one or more directions.

15. The support frame (200) according to claim 14, further comprising a support assembly (230) adjustable in the first direction (z), the second direction (x), the third direction (y), and/or a predetermined rotating angle, and configured to allow the impact device (140) of the actuator device (100) to impact the battery (150) from one or more directions.

## Patentansprüche

1. Aktuatorvorrichtung (100) zum Testen von Batterien, umfassend;
ein Gehäuse (110), umfassend
ein Gestell (120) und
mindestens eine Schutzplatte (130), die an dem Gestell (120) durch Befestigungsmittel montiert ist; und
mindestens eine Schlagvorrichtung (140), die konfiguriert ist, um auf eine Batterie (150) einzuschlagen und die an dem Gehäuse (110) befestigt ist, wobei mindestens eine Schutzplatte (130) der mindestens einen Schutzplatte (130) eine Schlagvorrichtungs-Schutzplatte ist, umfassend eine Öffnung (160), durch die ein Schlagelement (145) der Schlagvorrichtung (140) zu der Batterie (150) hin geführt wird,
**dadurch gekennzeichnet, dass**
die Schlagvorrichtung (140) an dem Gehäuse (110) auf einer Seite einer ersten Seite und einer zweiten Seite der Schlagvorrichtungs-Schutzplatte (130), die von der Batterie (150) abgewandt ist, befestigt werden kann.

2. Aktuatorvorrichtung (100) nach Anspruch 1, wobei das Gehäuse (110) mindestens zwei Schutzplatten (130) umfasst, wobei die mindestens zwei Schutzplatten (130) konfiguriert sind, um an verschiedenen Seiten des Gehäuses (110) montiert zu werden.

3. Aktuatorvorrichtung (100) nach Anspruch 1 oder 2, wobei das Gehäuse (110) mindestens zwei Schutzplatten (130) umfasst, wobei mindestens zwei der mindestens zwei Schutzplatten (130) Schlagvorrichtungs-Schutzplatten (130a, 130b) sind und wobei die mindestens eine Schlagvorrichtung (140) an der ersten Schutzplatte (130a) oder der zweiten Schutzplatte (130b) austauschbar befestigt werden kann.

4. Aktuatorvorrichtung (100) nach Anspruch 3, wobei eine Platte der mindestens zwei Schutzplatten (130) eine Fixierungsplatte (131) ausbildet, die Aktuatorvorrichtung (100) ferner umfassend eine Fixierungsvorrichtung, die optional an der Fixierungsplatte (131) angebracht ist und konfiguriert ist, um mindestens die Batterie (150) im Inneren des Gehäuses (110) zu fixieren.

5. Aktuatorvorrichtung nach einem der Ansprüche 3 oder 4, wobei eine Platte der mindestens zwei Schutzplatten (130) eine Fixierungsplatte (131) ausbildet, und wobei die Schlagvorrichtung (140) an einer ersten Außenseite (111) des Gehäuses (110) gegenüber der Fixierungsplatte (131) befestigt ist, und wobei der Schlag auf die Batterie (150) in einer ersten Richtung z senkrecht zu der Fixierungsplatte (131) durchgeführt wird.

6. Aktuatorvorrichtung 10 nach einem der Ansprüche 3 bis 5, wobei eine Platte der Vielzahl von Schutzplatten eine Fixierungsplatte (131) ausbildet und wobei die Schlagvorrichtung (140) an einer zweiten Außenseite (112) des Gehäuses (110) befestigt ist, die senkrecht zu der Fixierungsplatte (131) ist, und wobei der Schlag auf die Batterie (150) in einer zweiten Richtung x parallel zu der Fixierungsplatte (131) durchgeführt wird.

7. Aktuatorvorrichtung (100) nach einem der Ansprüche 3 bis 6, wobei die Schlagvorrichtung (140) an einer dritten Außenseite des Gehäuses (110) angebracht ist, die senkrecht zu der zweiten Außenseite (112) und der Fixierungsplatte (131) ist, und wobei der Schlag auf die Batterie (150) in einer dritten Richtung parallel zu der Fixierungsplatte (131) und senkrecht zu der zweiten Richtung x parallel zu der Fixierungsplatte (131) durchgeführt wird.

8. Aktuatorvorrichtung (100) nach Anspruch 7, wobei die Aktuatorvorrichtung (100) mindestens zwei Schlagvorrichtungen (140) umfasst, wobei jede der mindestens zwei Schlagvorrichtungen (140) an einer Seite der ersten Außenseite, der zweiten Außenseite oder der dritten Außenseite des Gehäuses (110) befestigt ist, an der die andere Schlagvorrichtung nicht befestigt ist.

9. Aktuatorvorrichtung (100) nach einem der vorstehenden Ansprüche, wobei die mindestens eine Schlagvorrichtung (140) einen Linearaktuator, wie einen elektrischen Linearmotor oder einen Pneumatikzylinder, einen Hydraulikzylinder, ein Bolzenschussgerät, eine Schusseinrichtung oder eine Nachspannvorrichtung umfasst.

10. Aktuatorvorrichtung (100) nach einem der vorstehenden Ansprüche, wobei das Aufprallelement (145) einen Endabschnitt umfasst, umfassend einen Nagel, eine Nadel, einen Bolzen oder ein Projektil oder eine kugelförmige oder prismatische Kugel, der konfiguriert ist, um auf die Batterie einzuschlagen.

11. Aktuatorvorrichtung (100) nach Anspruch 10, wobei die Schlagvorrichtung (145) einen Welle und/oder einen Adapter (180) umfasst, die konfiguriert sind, um den Endabschnitt mit der Schlagvorrichtung (140) mechanisch zu koppeln.

12. Aktuatorvorrichtung (100) nach einem der vorstehenden Ansprüche, ferner umfassend eine automatische Zuführvorrichtung (170), die konfiguriert ist, um nacheinander eine Vielzahl von Batterien (150) in das Innere des Gehäuses (110) der Aktuatorvorrichtung (100) einzuführen und zu ermöglichen, dass die Vielzahl von Batterien (150) durch die Schlagvorrichtung (140) getestet wird.

13. Aktuatorvorrichtung (100) nach einem der vorstehenden Ansprüche, wobei das Gehäuse (110) mindestens drei Schutzplatten, die an dem Gestell austauschbar montiert sind, mindestens vier Schutzplatten, die an dem Gestell (120) austauschbar montiert sind, mindestens fünf Schutzplatten, die an dem Gestell (120) austauschbar montiert sind oder mindestens sechs Schutzplatten, die an dem Gestell (120) austauschbar montiert sind, umfasst.

14. Trägerrahmen (200), der konfiguriert ist, um eine Batterie (150) zu fixieren, wobei eine Aktuatorvorrichtung (100) nach einem der vorstehenden Ansprüche an dem Trägerrahmen (200) durch Verbindungsmittel befestigt ist, derart, dass die Batterie (150) aus einer oder mehreren Richtungen beaufschlagt werden kann.

15. Trägerrahmen (200) nach Anspruch 14, der ferner umfassend eine Trägeranordnung (230), die in der ersten Richtung (z), der zweiten Richtung (x), der dritten Richtung (y) und/oder einem vorbestimmten Drehwinkel einstellbar und konfiguriert ist, um zu ermöglichen, dass die Schlagvorrichtung (140) der Aktuatorvorrichtung (100) aus einer oder mehreren Richtungen auf die Batterie (150) schlagen kann.

## Revendications

1. Dispositif d'actionnement (100) permettant de tester des batteries, comprenant :
un boîtier (110) comprenant
un support (120) et
au moins un panneau de protection (130) qui est monté sur le support (120) par des moyens d'attache ; et
au moins un dispositif d'impact (140) qui est conçu pour impacter une batterie (150) et attaché au boîtier (110), dans lequel au moins un panneau de protection (130) de l'au moins un panneau de protection (130) est un panneau de protection du dispositif d'impact comprenant une ouverture (160) à travers laquelle un élément d'impact (145) du dispositif d'impact (140) est acheminé vers la batterie (150),
**caractérisé en ce que**,
le dispositif d'impact (140) peut être attaché au boîtier (110) sur un côté d'un premier et un second côté du panneau de protection du dispositif d'impact (130) qui sont orientés à l'opposé de la batterie (150).

2. Dispositif d'actionnement (100) selon la revendication 1, dans lequel le boîtier (110) comprend au moins deux panneaux de protection (130), dans lequel les au moins deux panneaux de protection (130) sont conçus pour être montés sur différents côtés du boîtier (110).

3. Dispositif d'actionnement (100) selon la revendication 1 ou 2, dans lequel le boîtier (110) comprend au moins deux panneaux de protection (130), dans lequel au moins deux des au moins deux panneaux de protection (130) sont des panneaux de protection de dispositif d'impact (130a, 130b) et dans lequel l'au moins un dispositif d'impact (140) peut être attaché de manière interchangeable au premier panneau de protection (130a) ou au second panneau de protection (130b).

4. Dispositif d'actionnement (100) selon la revendication 3, dans lequel un panneau des au moins deux panneaux de protection (130) forme un panneau de fixation (131), le dispositif d'actionnement (100) comprenant en outre un dispositif de fixation éventuellement attaché au panneau de fixation (131) et conçu pour au moins fixer la batterie (150) à l'intérieur du boîtier (110).

5. Dispositif d' actionnement selon l'une quelconque des revendications 3 ou 4, dans lequel un panneau des au moins deux panneaux de protection (130) forme un panneau de fixation (131), et dans lequel le dispositif d'impact (140) est attaché à un premier côté extérieur (111) du boîtier (110) opposé au panneau de fixation (131), et dans lequel l'impact sur la batterie (150) est effectué dans une première direction z perpendiculaire au panneau de fixation (131).

6. Dispositif d'actionnement 10 selon l'une quelconque des revendications 3 à 5, dans lequel un panneau de la pluralité de panneaux de protection forme un panneau de fixation (131) et dans lequel le dispositif d'impact (140) est attaché à un deuxième côté extérieur (112) du boîtier (110) qui est perpendiculaire au panneau de fixation (131) et dans lequel l'impact sur la batterie (150) est effectué dans une deuxième direction x parallèle au panneau de fixation (131).

7. Dispositif d'actionnement (100) selon l'une quelconque des revendications 3 à 6, dans lequel le dispositif d'impact (140) est attaché à un troisième côté extérieur du boîtier (110) qui est perpendiculaire au deuxième côté extérieur (112) et au panneau de fixation (131) et dans lequel l'impact sur la batterie (150) est effectué dans une troisième direction parallèle au panneau de fixation (131) et perpendiculaire à la deuxième direction x parallèle au panneau de fixation (131).

8. Dispositif d'actionnement (100) selon la revendication 7, dans lequel le dispositif d'actionnement (100) comprend au moins deux dispositifs d'impact (140), dans lequel chacun des au moins deux dispositifs d'impact (140) est attaché à un côté du premier côté extérieur, du deuxième côté extérieur ou du troisième côté extérieur du boîtier (110) auquel l'autre dispositif d'impact n'est pas attaché.

9. Dispositif d' actionnement (100) selon l'une quelconque des revendications précédentes, dans lequel l'au moins un dispositif d'impact (140) comprend un actionneur linéaire, tel qu'un moteur linéaire électrique ou un cylindre pneumatique, un cylindre hydraulique, un pistolet à boulon captif, un appareil de tir, ou un dispositif de retensionnement.

10. Dispositif d' actionnement (100) selon l'une quelconque des revendications précédentes, dans lequel l'élément d'impact (145) comprend une section d'extrémité comprenant un clou, une aiguille, un boulon, ou un projectile, ou une bille sphérique ou prismatique, conçu pour impacter la batterie.

11. Dispositif d'actionnement (100) selon la revendication 10, dans lequel l'élément d'impact (145) comprend un arbre et/ou un adaptateur (180) conçu pour accoupler mécaniquement la section d'extrémité au dispositif d'impact (140).

12. Dispositif d' actionnement (100) selon l'une quelconque des revendications précédentes, comprenant en outre un dispositif d'alimentation automatique (170), conçu pour insérer de manière séquentielle une pluralité de batteries (150) à l'intérieur du boîtier (110) du dispositif d'actionnement (100), et pour permettre à la pluralité de batteries (150) d'être testée par le dispositif d'impact (140).

13. Dispositif d'actionnement (100) selon l'une quelconque des revendications précédentes, dans lequel le boîtier (110) comprend au moins trois panneaux de protection montés de manière interchangeable sur le support, au moins quatre panneaux de protection montés de manière interchangeable sur le support (120), au moins cinq panneaux de protection montés de manière interchangeable sur le support (120), ou au moins six panneaux de protection montés de manière interchangeable sur le support (120).

14. Cadre de support (200), conçu pour fixer une batterie (150), dans lequel un dispositif d'actionnement (100) selon l'une quelconque des revendications précédentes est attaché au cadre de support (200) par des moyens de liaison de telle sorte que la batterie (150) peut être impactée dans une ou plusieurs directions.

15. Cadre de support (200) selon la revendication 14, comprenant en outre un ensemble de support (230) réglable dans la première direction (z), la deuxième direction (x), la troisième direction (y), et/ou un angle de rotation prédéterminé, et conçu pour permettre au dispositif d'impact (140) du dispositif d'actionnement (100) d'impacter la batterie (150) à partir d'une ou de plusieurs directions.
